# EUROPEAN PATENT APPLICATION

(11) **EP 2 757 863 A2**
(43) Date of publication of application: **23.07.2014**
(21) Application number: 13193259.2
(22) Date of filing: 18.11.2013
(51) Int. Cl.: H05K 1/14

(54) **Printed circuit board stack**

(30) Priority: 17.01.2013 JP 2013006760
(71) Applicant: Sumitomo Wiring Systems, Ltd., Yokkaichi Mie 510-8503 (JP)
(72) Inventor: Shi, Wenjie, Yokkaichi, Mie 510-8503 (JP)
(74) Representative: Horn Kleimann Waitzhofer

(57) **Abstract**

Provided is a printed circuit board stack having a new structure that can connect between printed wirings of printed circuit boards that are arranged so as to face each other across a gap, with an improved operability and connection stability. With respect to a first printed circuit board (18) and a second printed circuit board (20) that are arranged so as to face each other across a gap, a first fork terminal (26) that is soldered to a printed wiring (32) is vertically provided on the first printed circuit board (18), whereas a second fork terminal (34) that is soldered to a printed wiring (36) is vertically provided on the second printed circuit board (20). The printed wiring (32) of the first printed circuit board (18) and the printed wiring (36) of the second printed circuit board (20) are electrically connected to each other via a conductive member (56) that is provided with a pair of connection portions (57) that each are pressure-contacted between pressure contact blades (28) of each of the first fork terminal (26) and the second fork terminal (34).

## Description

### TECHNICAL FIELD

The present invention relates to a printed circuit board stack in which two printed circuit boards that are arranged so as to face each other across a gap are electrically connected to each other via conductive members that each are connected to printed wirings on the respective printed circuit boards.

### BACKGROUND ART

Conventionally, as an electrical junction box that is installed in an automobile, an electrical junction box is known in which a printed circuit board is accommodated inside so as to configure an internal circuit. Particularly in recent years, due to an increase in the number of in-vehicle electrical components, an electrical junction box as disclosed in JP H7-297562A (Patent Document 1) that includes a printed circuit board stack in which two printed circuit boards are arranged so as to face each other across a gap has been proposed.

In order to connect the printed wirings on the printed circuit boards of such a printed circuit board stack to each other, two ends of each rod-shaped inter-board connection terminal may be inserted into through-holes provided near the printed wirings of the two printed circuit boards and soldered thereto.

However, in a conventional printed circuit board stack having such a structure, there is the problem that an operation in which one end of the inter-board connection terminal is soldered to one printed circuit board, and then the other end of the inter-board connection terminal is positioned and inserted into the through-hole of the other printed circuit board and soldered thereto is very complicated and takes time.

Also, since the two ends of the rod-shaped inter-board connection terminal are respectively connected to the two printed circuit boards by soldering, the displacement of the two printed circuit boards with respect to each other due to, for example, a load applied to one printed circuit board causes a large load to be applied to the soldered portions of the inter-board connection terminal. Therefore, solder cracking may easily occur at the soldered portions of the inter-board connection terminal, meaning that connection stability between the two boards is not sufficiently secured.

JP H7-297562A (Patent Document 1) is an example of related art.

The present invention is made in view of the above-described circumstances, and a problem to be solved is to provide a printed circuit board stack having a new structure that can provide a connection between printed wirings of printed circuit boards arranged so as to face each other across a gap, with an improved operability and connection stability.

### SUMMARY OF THE INVENTION

A first aspect of the present invention is a printed circuit board stack including a first printed circuit board and a second printed circuit board that are arranged so as to face each other across a gap, wherein a first fork terminal that is soldered to a first printed wiring is vertically arranged on the first printed circuit board whereas a second fork terminal that is soldered to a second printed wiring is vertically arranged on the second printed circuit board, and the first printed wiring of the first printed circuit board and the second printed wiring of the second printed circuit board are electrically connected to each other via a conductive member that is provided with a pair of connection portions, each connection portion being pressure-contacted between pressure contact blades of a respective one of the first fork terminal and the second fork terminal.

In the printed circuit board stack configured according to the present invention, by mounting the conductive member while being arranged on both the fork terminals that are respectively soldered to and vertically provided on the first printed circuit board and the second printed circuit board, the printed wiring of the first printed circuit board and the printed wiring of the second printed circuit board can be electrically connected to each other. With this, it is possible to omit an inter-board connection terminal whose two ends are soldered to two printed circuit boards as in the conventional structure, and also to omit a complicated operation in which one end of the inter-board connection terminal is soldered to one printed circuit board, then the other end is inserted into a through-hole of the other printed circuit board and soldered thereto, and the like. As a result, operability of an operation for connecting the first printed circuit board and the second printed circuit board can be improved. Further, it is possible to prevent the problem of the inter-board connection terminal, that is, the occurrence of solder cracking that is caused due to the displacement between the two printed circuit boards to which the two ends of the inter-board connection terminal are soldered, and also to improve the stability of connection between the printed circuit boards.

In addition, since the fork terminals that each are provided with pressure contact blades are vertically provided on the first printed circuit board and the second printed circuit board, and the connection portions of the conductive member are connected to the fork terminals while being pressure-contacted between the corresponding pressure contact blades, the operation for connecting the conductive member to the first fork terminal and to the second fork terminal can easily be performed. Furthermore, by using the pressure contact force of the pressure contact blades, it is possible to maintain a stable electrical connection between the conductive member and the fork terminals, allowing an improvement in stability of connection between the first printed circuit board and the second printed circuit board.

Note that the conductive member may be a member that includes a pair of connection portions, each connection portion being pressure-contacted between pressure contact blades of a respective one of the first fork terminal and the second fork terminal, and may be, for example, a busbar or the like that is made from a metallic plate, a general-purpose fuse, a so-called short pin that has the same shape as that of the fuse and does not include a portion to be fused, or the like.

A second aspect of the present invention is the printed circuit board stack of the first aspect, wherein the conductive member includes at least one selected from a fuse and a short pin and, by the first fork terminal and the second fork terminal having different heights, the pressure contact blades of the first fork terminal and the pressure contact blades of the second fork terminal are arranged at the same level with respect to a direction in which the first printed circuit board and the second printed circuit board face each other. The first printed circuit board and the second printed circuit board may extend parallel to each other, with a gap between them, in which case the "direction in which the first printed circuit board and the second printed circuit board face each other" is the direction orthogonal to the planes of the first and second printed circuit board.

According to this aspect, the pressure contact blades of the first fork terminal and the pressure contact blades of the second fork terminal are arranged at the same level with respect to a direction in which the conductive member is connected. Therefore, it is possible to advantageously use, as the conductive member, a general-purpose fuse, a general-purpose short pin, or the like that has a pair of connection portions formed at the same level with respect to a direction in which the pair of connection portions is connected to the fork terminals.

Also, by using, as the conductive member, a fuse to be connected between the printed wirings, a short pin that branches and connects the printed wirings, or the like to connect the first printed circuit board and the second printed circuit board, it is possible to omit an inter-board connection terminal that is used only for connecting between two printed circuit boards, allowing an efficient use of spaces of the printed circuit boards and downsizing of the printed circuit boards.

A third aspect of the present invention is the printed circuit board stack of the first or second aspect, wherein the first fork terminal is vertically provided at a peripheral edge portion of the first printed circuit board whereas the second fork terminal is vertically provided at a peripheral edge portion of the second printed circuit board, the peripheral edge portion of the second printed circuit board separated from the first printed circuit board across a gap is located inward of the peripheral edge portion of the first printed circuit board, the first fork terminal projects towards and beyond a plane in which the second printed circuit board is arranged, and the pressure contact blades of the first fork terminal and the pressure contact blades of the second fork terminal are arranged so as to face each other in a direction in which the first and second printed circuit board extend.

According to this aspect, the peripheral edge portion of the first printed circuit board is separated from the peripheral edge portion of the second printed circuit board in the horizontal direction, and the first fork terminal and the second fork terminal are vertically provided at the peripheral edge portions of the respective printed circuit boards. Accordingly, it is possible to arrange the first fork terminal and the second fork terminal, together with the conductive member to be connected to the first fork terminal and the second fork terminal, that are used for connecting the first printed circuit board and the second printed circuit board, at the peripheral edge portions of the respective first printed circuit board and the second printed circuit board. This makes it possible to ensure spaces in the respective central portions of the first printed circuit board and the second printed circuit board and to achieve an efficient use of the printed circuit boards. Also, since the first fork terminal of the first printed circuit board projects upward beyond the second printed circuit board by locating the peripheral edge portion of the second printed circuit board inward of the peripheral edge portion of the first printed circuit board, the second printed circuit board does not need to have a through-hole or a cut-out through which the first fork terminal is inserted. Accordingly, it is possible to easily manufacture the second printed circuit board in a simple shape, and to perform connection between the boards while efficiently maintaining the rigidity of the second printed circuit board.

In the present invention, a first fork terminal and a second fork terminal that are each provided with pressure contact blades are respectively vertically provided on a first printed circuit board and a second printed circuit board that are arranged in a stack, and a pair of connection portions of a conductive member is connected to the pressure contact blades of the first fork terminal and to the pressure contact blades of the second fork terminal, and thereby a printed wiring of the first printed circuit board and a printed wiring of the second printed circuit board are connected to each other. Accordingly, since it is not necessary, unlike in the case using the conventional inter-board connection terminal, to perform a complicated operation in which two ends of the inter-board connection terminal are inserted into through-holes of the respective printed circuit boards and soldered thereto, and the like, excellent assembly operability can be achieved. Further, since the connections of the conductive member are connected to the pressure contact blades of the first fork terminal of the first printed circuit board and to the pressure contact blades of the second fork terminal of the second printed circuit board while being pressure-contacted therebetween, it is possible to easily perform connection between the conductive member and the fork terminals, and to maintain a stable connection state.

### BRIEF DESCRIPTION OF THE DRAWINGS

Fig. 1 is a cross-sectional view illustrating an electrical junction box in which a printed circuit board stack according to a first embodiment of the present invention is accommodated.
Fig. 2 is a top view illustrating the printed circuit board stack shown in Fig. 1.
Fig. 3 is an enlarged view illustrating a main portion that is seen in a direction A of Fig. 2.
Fig. 4 is an enlarged view illustrating the main portion that is seen in a direction B of Fig. 2.
Fig. 5 is a top view illustrating a main portion of a printed circuit board stack according to a second embodiment of the present invention.
Fig. 6 is a top view illustrating a main portion of a printed circuit board stack according to a third embodiment of the present invention.

### EMBODIMENTS OF THE INVENTION

Hereinafter, embodiments of the present invention will be described with reference to the accompanied drawings.

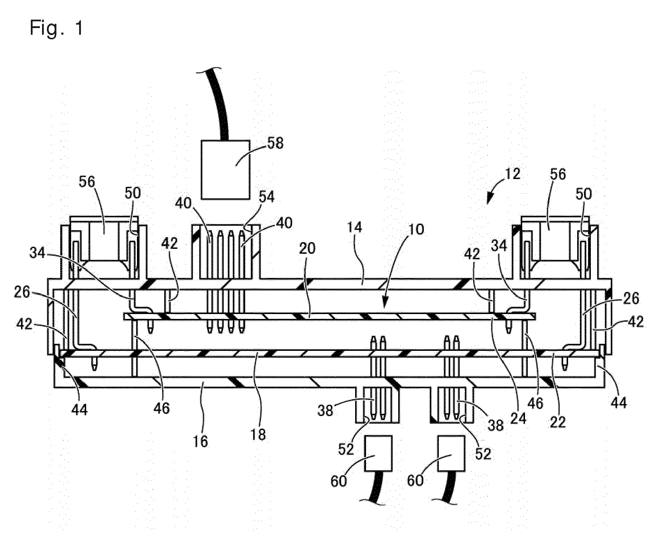

First, Fig. 1 shows an electrical junction box 12 provided with a printed circuit board stack 10 according to a first embodiment of the present invention. The electrical junction box 12 has a structure in which the printed circuit board stack 10 is accommodated between an upper case 14 and a lower case 16 that are made from a synthetic resin. Note that, in the following description, "upper" refers to the upper side of Fig. 1, that is, on the side of the upper case 14, whereas "lower" refers to the lower side of Fig. 1, that is, on the side of the lower case 16.

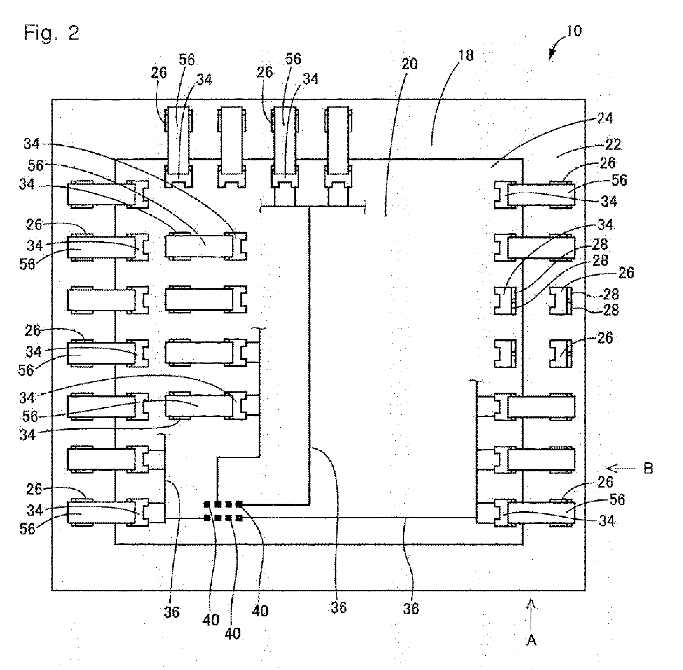

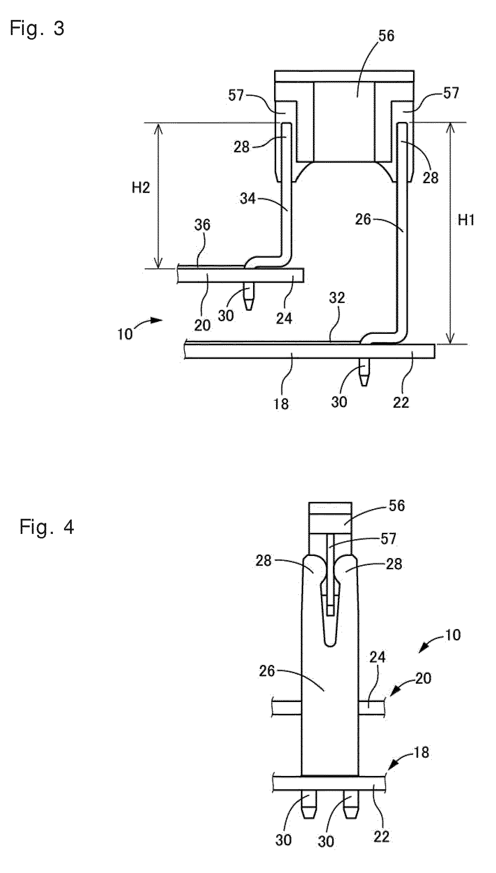

Fig. 2 shows a top view of the printed circuit board stack 10, and Figs. 3 and 4 show the main portion of the printed circuit board stack 10. Note that Figs. 2 to 4 also show a fuse 56, which will be described later, for the sake of easy understanding. The printed circuit board stack 10 has a structure in which a second printed circuit board 20 is arranged above a first printed circuit board 18 across a gap so as to face thereto. The first printed circuit board 18 and the second printed circuit board 20 are each configured to be in the shape of a substantially rectangular plate. The second printed circuit board 20 is configured to have a size that is smaller than that of the first printed circuit board 18 when seen in the top view (see Fig. 2). Accordingly, a peripheral edge portion 24 of the second printed circuit board 20 is located, when seen in the top view, inward of a peripheral edge portion 22 of the first printed circuit board 18 and, in the present embodiment, the peripheral edge portion 22 of the first printed circuit board 18 projects outward from the entire perimeter of the peripheral edge portion 24 of the second printed circuit board 20.

A plurality of first fork terminals 26 are vertically provided at the peripheral edge portion 22 of the first printed circuit board 18. Each first fork terminal 26 is made in one piece from a metal sheet, and one end thereof is substantially U-shaped, like a fork such that a pair of pressure contact blades 28 is formed so as to face each other across a gap. The other end of the first fork terminal 26 that is opposite to the pressure contact blades 28 is provided with a pair of soldered portions 30. Note that the soldered portions 30 of the present embodiment are bent in the shape of cranks and configured to be able to support the first fork terminal 26 against the push-in force of the fuse 56 by abutting on the first printed circuit board 18 at the time of connection of the fuse 56, which will be described later. However, the soldered portions 30 may also be in the shape extending straight in the longitudinal direction of the first fork terminal 26 (vertical direction of Figs. 3 and 4). By such soldered portions 30 of the first fork terminal 26 being inserted into through-holes (not shown) provided at the peripheral edge portion 22 of the first printed circuit board 18 and soldered to a printed wiring 32 that serves as a first printed wiring and is formed on the first printed circuit board 18, the plurality of first fork terminals 26 are vertically provided with an appropriate distance at the peripheral edge portion 22 in the circumferential direction of the peripheral edge portion 22. Note that, in the present embodiment, the plurality of first fork terminals 26 are arranged over three sides of the peripheral edge portion 22 of the first printed circuit board 18.

On the other hand, a plurality of second fork terminals 34 are vertically provided at the peripheral edge portion 24 of the second printed circuit board 20. In the drawings, the same reference numerals as those of the first fork terminals 26 are given to portions of the second fork terminals 34 that have the same structure as those of the first fork terminals 26, and descriptions thereof are omitted. That is, the second fork terminals 34 each differ from the first fork terminals 26 in the size of length (size in the vertical direction in Figs. 3 and 4), and have a length that is shorter than that of the first fork terminals 26. Similarly to the case of the first fork terminals 26, such second fork terminals 34 are vertically provided at the peripheral edge portion 24 of the second printed circuit board 20 by the soldered portions 30 of the second fork terminals 34 being soldered to a printed wiring 36, serving as a second printed wiring, of the second printed circuit board 20. Note that, as is clear from Fig. 2, by arranging a pair of second fork terminals 34 in the central portion of the second printed circuit board 20 so that the pair of second fork terminals 34 face each other, it is of course also possible to form a fuse connection similar to a conventional one.

Also, as shown in Fig. 1, a plurality of output connector connection terminals 38, serving as metallic terminals, are soldered to the first printed circuit board 18 and provided so as to project to the side opposite to the second printed circuit board 20. On the other hand, a plurality of input connector connection terminals 40, serving as metallic terminals, are soldered to the second printed circuit board 20 and provided so as to project to the side opposite to the first printed circuit board 18. Metallic terminals in various types of shapes may appropriately be applied to these output connector connection terminals 38 and the input connector connection terminals 40, depending on output connectors 60 or an input connector 58, which are described later. For example, metallic terminals in a suitable shape, such as the shape of a pin having a square cross-section or a circular cross-section, or a tab having a rectangular cross-section can be employed. The output connector connection terminals 38 are soldered to the printed wiring 32 (see Fig. 3) on the first printed circuit board 18 and electrically connected to at least one of the plurality of first fork terminals 26, while the input connector connection terminals 40 are soldered to the printed wiring 36 on the second printed circuit board 20 and electrically connected to at least one of the plurality of second fork terminals 34.

The first printed circuit board 18 and the second printed circuit board 20 of the present embodiment are respectively supported by the upper case 14 and the lower case 16, and thereby are positioned facing each other across a gap. For example, the first printed circuit board 18 is supported between the support bosses 42 that project from the upper case 14 and a support wall 44, which is formed at an inner surface of the peripheral wall of the lower case 16. On the other hand, the second printed circuit board 20 is supported between support bosses 42 that project from the upper case 14 and support bosses 46, which project from the lower case 16 and are inserted into through-holes (not shown) provided on the second printed circuit board 20. However, the present invention is no way limited to the specific configuration in which the first printed circuit board 18 and the second printed circuit board 20 are positioned in a stacked state, and a configuration is also applicable in which, for example, an insulating plate made from a synthetic resin is disposed between the first printed circuit board 18 and the second printed circuit board 20, and both the first printed circuit board 18 and the second printed circuit board 20 are fixed to the insulating plate.

By positioning the first printed circuit board 18 and the second printed circuit board 20 with respect to each other in a stacked state, the peripheral edge portion 24 of the second printed circuit board 20 is positioned inward of the peripheral edge portion 22 of the first printed circuit board 18. Since, as described above, the first fork terminal 26 is configured to have a length that is longer than that of the second fork terminal 34, as shown in Fig. 3, the height H1 of the first fork terminal 26 from the first printed circuit board 18 is greater than the height H2 of the second fork terminal 34 from the second printed circuit board 20, and the first fork terminal 26 projects upward (to the upper side in Fig. 3) beyond the second printed circuit board 20. Accordingly, the pressure contact blades 28 of the first printed circuit board 18 and the pressure contact blades 28 of the second printed circuit board 20 are arranged so as to face each other in the horizontal direction (lateral direction in Fig. 3), and are arranged at the same level with respect to the vertical direction in which the first printed circuit board 18 and the second printed circuit board 20 face each other (vertical direction in Fig. 3).

The printed circuit board stack 10 that has such a structure is accommodated between the upper case 14 and the lower case 16. Accordingly, as shown in Fig. 1, the first fork terminal 26 and the second fork terminal 34 that face each other are inserted into terminal insertion holes (not shown) provided on the upper case 14, and are arranged in each of a plurality of fuse accommodation cavities 50 provided on the upper case 14. Also, the output connector connection terminals 38 vertically provided on the first printed circuit board 18 are inserted into terminal insertion holes (not shown) provided on the lower case 16, and are arranged in output connector accommodation cavities 52 formed on the lower case 16. Further, the input connector connection terminals 40 vertically provided on the second printed circuit board 20 are inserted into terminal insertion holes (not shown) provided on the upper case 14, and are arranged in an input connector accommodation cavity 54 provided on the upper case 14.

Also, a fuse 56, which serves as a conductive member, is inserted into each fuse accommodation cavity 50. Each fuse 56 is a conventionally well-known fuse and provided with a pair of connection portions 57 in the shape of plates that are provided in a projecting manner and connected to each other via a portion to be fused (not shown). When such a fuse 56 is inserted into each fuse accommodation cavity 50, one of the connection portions 57 is pressure-contacted between the pressure contact blades 28 of the first fork terminal 26 and the other of the connection portions 57 is pressure-contacted between the pressure contact blades 28 of the second fork terminal 34, in each fuse accommodation cavity 50 (see Figs. 3 and 4). Accordingly, the fuse 56 is connected to the first fork terminal 26 and the second fork terminal 34, and the printed wiring 32 of the first printed circuit board 18 and the printed wiring 36 of the second printed circuit board 20 are electrically connected to each other via the fuse 56.

Further, when the input connector 58 provided at the end of a wire harness that is connected to a battery, for example, is inserted into the input connector accommodation cavity 54, the input connector 58 is connected to the input connector connection terminals 40 and electrically connected to the printed wiring 36 (see Fig. 3) of the second printed circuit board 20. Also, when an output connector 60 provided at the end of a wire harness that is connected to, for example, an electrical component of an automobile serving as a load is inserted into the output connector accommodation cavity 52, the output connector 60 is connected to the output connector connection terminals 38 and electrically connected to the printed wiring 32 of the first printed circuit board 18. As a result, the input connector 58 is electrically connected to the output connector 60 via the second printed circuit board 20, the second fork terminal 34, the fuse 56, the first fork terminal 26, and the first printed circuit board 18, and thus an electrically-conducting path that connects the input connector 58 and the output connector 60 is formed via the printed circuit board stack 10.

The printed circuit board stack 10 that has such a structure is configured such that the first fork terminal 26 and the second fork terminal 34 that are respectively vertically provided on the first printed circuit board 18 and the second printed circuit board 20 are connected to each other via the fuse 56, and thereby the printed wiring 32 of the first printed circuit board 18 and the printed wiring 36 of the second printed circuit board 20 are electrically connected to each other. Therefore, since it is not necessary, unlike in a conventional structure in which both printed circuit boards are connected to each other by a large number of inter-board connection terminals, to perform a complicated operation in which each one end of the large number of inter-board connection terminals is soldered to one printed circuit board, then each other end thereof is inserted into a through-hole of the other printed circuit board and soldered thereto, and the like, it is possible to achieve easy connection between the first printed circuit board 18 and the second printed circuit board 20. Further, by using the pressure contact force of the pressure contact blades 28 of the first fork terminal 26 and the pressure contact force of the pressure contact blades 28 of the second fork terminal 34, it is possible to stably connect both of the first fork terminal 26 and the second fork terminal 34 to the fuse 56, and to prevent the solder cracking that occurs due to the displacement of the printed circuit boards in the conventional inter-board connection terminal, achieving an improvement in the reliability of connection between the first printed circuit board 18 and the second printed circuit board 20. Also, since inter-board connection terminals that are used only for connecting between the printed circuit boards are not necessary, the number of constituent components can be reduced.

Furthermore, in the present embodiment, the first fork terminals 26 and the second fork terminals 34 are respectively vertically provided at the peripheral edge portions 22 and 24 of the first printed circuit board 18 and the second printed circuit board 20. With this, effective spaces of the first printed circuit board 18 and the second printed circuit board 20 can be ensured more advantageously, achieving more efficient use of the first printed circuit board 18 and the second printed circuit board 20, and downsizing of the printed circuit board stack 10.

In addition, by positioning the peripheral edge portion 24 of the second printed circuit board 20 inward of the peripheral edge portion 22 of the first printed circuit board 18, it is possible to arrange the second fork terminal 34 and the first fork terminal 26 that are vertically provided at the respective peripheral edge portions 24 and 22 so as to face each other. In particular, since the second printed circuit board 20 does not need to have insertion holes and the like through which the first fork terminals 26 project upward, it is possible to ensure the strength of the second printed circuit board 20, and since the shapes of the first printed circuit board 18 and the second printed circuit board 20 are made simple, it is possible to achieve a reduction in the manufacturing cost. Further, since the pressure contact blades 28 of the first fork terminal 26 and the pressure contact blades 28 of the second fork terminal 34 are located at the same level with respect to a direction in which the fuse 56 is inserted (direction from the upper side to the lower side in Fig. 3), a general-purpose fuse that is conventionally widely used can be employed as the fuse 56, thus allowing a reduction in the manufacturing cost. In addition, since the connection portions 57 of the fuse 56 can simultaneously be connected to the first fork terminal 26 and to the second fork terminal 34, it is possible to perform the connection operation more smoothly.

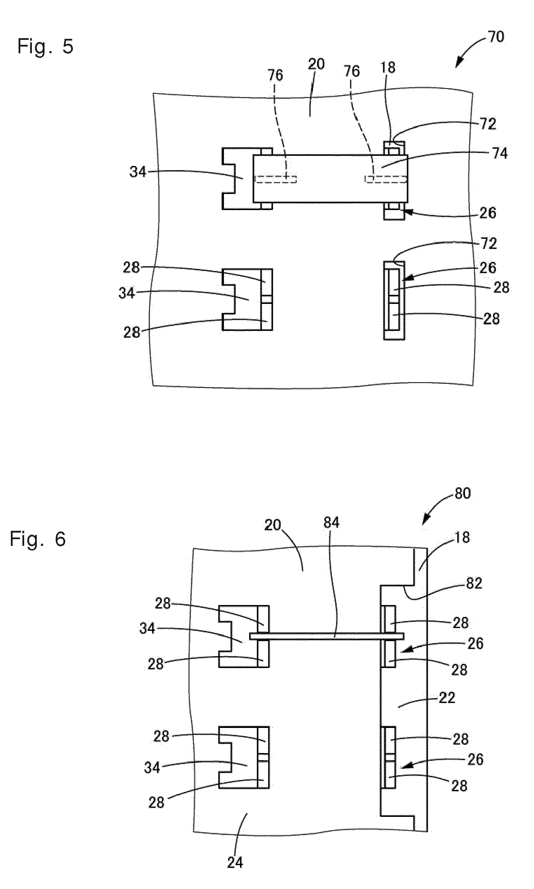

Next, Fig. 5 shows a top view of a main portion of a printed circuit board stack 70 as a second embodiment of the present invention. Note that, in the following description, the same reference numerals as those in the first embodiment are given in the drawings to the members and portions that have the same structures as those in the first embodiment, and descriptions thereof are omitted.

A first printed circuit board 18 and a second printed circuit board 20 according to the present embodiment have substantially the same size when seen in the top view. Through-holes 72 are provided in the central portion of the second printed circuit board 20. First fork terminals 26 that are vertically provided on the first printed circuit board 18 project upward of the second printed circuit board 20 while passing through the respective through-holes 72, and are arranged so as to face second fork terminals 34 that are vertically arranged on the second printed circuit board 20. In this manner, the first fork terminals 26 and the second fork terminals 34 may also be arranged at positions other than peripheral edge portions of the first printed circuit board 18 and the second printed circuit board 20.

Also, a short pin 74, which serves as a conductive member, is connected to the first fork terminal 26 and the second fork terminal 34 of the present embodiment. Although a detailed illustration is omitted, the short pin 74 has the same external shape as that of the fuse 56, and a pair of connection portions 76 that have the same shape as that of connection portions 57 of the fuse 56 is connected to the short pin 74 without a portion to be fused disposed therebetween. By such connection portion s 76 of the short pin 74 being pressure-contacted between the pressure contact blades 28 of the first fork terminal 26 and between the pressure contact blades 28 of the second fork terminal 34, as in the case of the fuse 56, the first fork terminal 26 and the second fork terminal 34 are electrically connected to each other via the short pin 74. In this way, the conductive member is not limited to a fuse. It is also possible to use both the fuse 56 and the short pin 74, and also to selectively use the fuse 56 and the short pin 74 for pairs of the first fork terminal 26 and the second fork terminal 34.

Next, Fig. 6 shows a top view of a main portion of a printed circuit board stack 80 according to a third embodiment of the present invention. In the present embodiment, a first printed circuit board 18 and a second printed circuit board 20 have substantially the same size, and a peripheral edge portion 24 of the second printed circuit board 20 is arranged above a peripheral edge portion 22 of the first printed circuit board 18 across a gap. A cut-out 82 that is cut inward the second printed circuit board 20 is formed at the peripheral edge portion 24 of the second printed circuit board 20, and first fork terminals 26 that are vertically provided at the peripheral edge portion 22 of the first printed circuit board 18 project upward of the second printed circuit board 20 while passing through the cut-out 82, and are arranged so as to face the second fork terminals 34 that are vertically provided at the peripheral edge portion 24 of the second printed circuit board 20. By providing the cut-out 82 at the peripheral edge portion 24 of the second printed circuit board 20 as in the present embodiment, it is also possible for the first fork terminals 26 to project upward. Note that although in Fig. 6, a plurality of the first fork terminals 26 are arranged in a common cut-out 82, it is of course possible to form a cut-out 82 for each first fork terminal 26.

Also, a busbar 84, which serves as a conductive member, is connected to the first fork terminal 26 and to the second fork terminal 34 of the present embodiment. The busbar 84 is in the shape of a flat plate obtained by punching a metallic sheet. Although a detailed illustration is omitted, the busbar 84 may also be in the shape of, for example, a long rectangular flat plate, the busbar 84 may be provided, if needed, with tab-shaped connection portions, that is, having a similar shape to that of the connection portions 57 of the fuse 56 and arranged in a projecting manner, or other configuration is also possible. By such a busbar 84 being pressure-contacted between the pressure contact blades 28 of the first fork terminal 26 and between the pressure contact blades 28 of the second fork terminal 34, the first fork terminal 26 and the second fork terminal 34 are electrically connected to each other via the busbar 84. Note that, in the present embodiment, instead of the busbar 84, it is of course also possible to use the fuse 56 or the short pin 74.

Although the embodiments of the present invention have been described in detail, the present invention is not limited by the specific descriptions of the embodiments. For example, the pressure contact blades of the first fork terminal and the pressure contact blades of the second fork terminal are not necessarily arranged at the same level with respect to a direction in which the first printed circuit board and the second printed circuit board face each other. In this case, another configuration is also possible in which, for example, first fork terminals and second fork terminals that are configured to have the same shape are arranged such that the pressure contact blades of the first fork terminals and the pressure contact blades of the second fork terminals are shifted with respect to each other, and connection portions of the conductive member are made longer.

Further, although the entire peripheral edge portion 24 of the second printed circuit board 20 according to the first embodiment is located inward of the first printed circuit board 18, another configuration is also possible in which, for example, only one side of the peripheral edge portion 24 is located inward of the first printed circuit board 18, and the first fork terminals 26 and the second fork terminals 34 are arranged only on that side.

Furthermore, in the above described embodiments, the numbers of the first fork terminals and the second fork terminals, the shape in which the printed wirings are routed, and the like are, of course, merely examples. The numbers of the first fork terminals and the second fork terminals and locations at which they are arranged, the shape in which the printed wirings are routed, and the like are items that can arbitrarily be set.

### LIST OF REFERENCE NUMERALS

- 10, 70, 80: Printed circuit board stack
- 12: Electrical junction box
- 14: Upper case
- 16: Lower case

- 18: First printed circuit board
- 20: Second printed circuit board
- 22: Peripheral edge portion (of first printed circuit board)
- 24: Peripheral edge portion (of second printed circuit board)
- 26: First fork terminal
- 28: Pressure contact blade
- 32: Printed wiring (first printed wiring)
- 34: Second fork terminal
- 36: Printed wiring (second printed wiring)
- 56: Fuse (conductive member)
- 57: Connection portion
- 58: Input connector
- 60: Output connector
- 72: Through-hole
- 74: Short pin (conductive member)
- 76: Connection portion
- 84: Busbar (conductive member)

## Claims

1. A printed circuit board stack (10, 70, 80) comprising a first printed circuit board (18) and a second printed circuit board (20) that are arranged so as to face each other across a gap,
wherein a first fork terminal (26) that is soldered to a first printed wiring (32) is vertically arranged on the first printed circuit board (18) whereas a second fork terminal (34) that is soldered to a second printed wiring (36) is vertically arranged on the second printed circuit board (20), and
the first printed wiring (32) of the first printed circuit board (18) and the second printed wiring (36) of the second printed circuit board (20) are electrically connected to each other via a conductive member (56) that is provided with a pair of connection portions (57), each connection portion (57) being pressure-contacted between pressure contact blades (28) of a respective one of the first fork terminal (26) and the second fork terminal (34).

2. The printed circuit board stack (10, 70, 80) according to claim 1,
wherein the conductive member (56) comprises at least one selected from a fuse and a short pin, and
the first fork terminal (26) and the second fork terminal (34) have different heights that are set such that the pressure contact blades (28) of the first fork terminal (26) and the pressure contact blades (28) of the second fork terminal (34) are arranged at the same level with respect to a direction in which the first printed circuit board (18) and the second printed circuit board (20) face each other.

3. The printed circuit board stack (10, 70, 80) according to claim 1 or 2,
wherein the first fork terminal (26) is vertically provided at a peripheral edge portion (22) of the first printed circuit board (18) whereas the second fork terminal (34) is vertically provided at a peripheral edge portion (24) of the second printed circuit board (20),
the peripheral edge portion (24) of the second printed circuit board (20) arranged separated from the first printed circuit board (18) across a gap is located inward of the peripheral edge portion (22) of the first printed circuit board (18),
the first fork terminal (26) projects towards and beyond a plane in which the second printed circuit board (20) is arranged, and
the pressure contact blades (28) of the first fork terminal (26) and the pressure contact blades (28) of the second fork terminal (34) are arranged so as to face each other in a direction in which the first and second printed circuit board (18, 20) extend.
